Europäisches Patentamt

European Patent Office

Office européen des brevets

(11) Veröffentlichungsnummer: **0 421 096 A2**

## (12) EUROPÄISCHE PATENTANMELDUNG

(21) Anmeldenummer: **90115492.2**

(22) Anmeldetag: **13.08.90**

(51) Int. Cl.5: **H05K 7/14**

(30) Priorität: **06.10.89 DE 3933319**

(43) Veröffentlichungstag der Anmeldung:
**10.04.91 Patentblatt 91/15**

(84) Benannte Vertragsstaaten:
**AT BE CH DE ES FR GB IT LI NL SE**

(71) Anmelder: **SENSYCON GESELLSCHAFT FÜR INDUSTRIELLE SENSORSYSTEME UND PROZESSLEITTECHNIK MBH**
**Hackethalstrasse 7**
**W-3000 Hannover 1(DE)**

(72) Erfinder: **Byell, Horst**
**Achatweg 6**
**W-3008 Garbson 1(DE)**
Erfinder: **Leidel, Erik**
**Hindenburgstrasse 26B**
**W-3012 Langenhagen(DE)**

(74) Vertreter: **Klein, Thomas, Dipl.-Ing. (FH) et al**
**Sodener Strasse 9 Postfach 6140**
**W-6231 Schwalbach a. Ts.(DE)**

(54) Elektronische Geräteanordnung.

(57) Die Erfindung bezieht sich auf eine elektronische Geräteanordnung für Schalttafel- oder Pulteinbau mit einem mantelartigen Gehäuse 1, dessen stirnseitige Öffnung 2 von einer Verschlußtafel 3 verschließbar ist. Etwa parallel zur Bodenfläche des Gehäuses 1 ist in diesem eine erste Leiterplatte 7 angeordnet, auf die etwa senkrecht nach oben stehend mindestens eine gegebenenfalls elektronische Bauteile tragende weitere Leiterplatte 9 mit der ersten Leiterplatte 7 elektrisch verbindend aufsteckbar ist. Die erste und die weiteren Leiterplatten 7 und 9 sind auf einem Leiterplattenhalter 6 anordenbar. An Steckanschlüssen 10, die mit der ersten Leiterplatte 7 elektrisch leitend verbunden sind, sind die zu externen Einheiten führenden Leitungen anschließbar. Der Leiterplattenhalter 6 ist im Bereich einer Randkante der stirnseitigen Öffnung 2 des Gehäuses 1 am Gehäuse 1 um eine Schwenkachse 5 schwenkbar angeordnet und aus seiner Einbaulage um die Schwenkachse 5 aus dem Gehäuse 1 herausschwenkbar.

Figur 1

EP 0 421 096 A2

# ELEKTRONISCHE GERÄTEANORDNUNG

Die Erfindung bezieht sich auf eine elektronische Geräteanordnung für Schalttafel- oder Pulteinbau mit einem mantelartigen Gehäuse, dessen eine stirnseitige Öffnung von einer Verschlußtafel verschliesbar ist, mit einer etwa parallel zur Bodenfläche des Gehäuses in diesem angeordneten ersten Leiterplatte, auf die etwa senkrecht nach oben stehend mindestens eine gegebenenfalls elektronische Bauteile tragende weitere Leiterplatte mit der ersten Leiterplatte elektrisch verbindend aufsteckbar ist, wobei die erste und die weiteren Leiterplatten auf einem Leiterplattenhalter anordenbar sind, mit Steckanschlüssen, die mit der ersten Leiterplatte elektrisch leitend verbunden sind und an die zu externen Einheiten führend Leitungen anschließbar sind.

Bei derartigen elektronischen Geräteanordnungen ist es äußerst aufwendig, z.B. zum Zwecke des Austauschs die weitere Leiterplatte aus dem Gehäuse zu entnehmen oder zur Ergänzung zusätzliche weitere Leiterplatten einzusetzen. Zum einen sind die Leiterplatten meist im Gehäuse nur schwer zugänglich angeordnet und zum anderen ist häufig der Ausbau anderer, vor den auszutauschenden oder zu ergänzenden Leiterplatten angeordnete Bauteile erforderlich.

Dies erfordert nicht nur einen erhebliche Montageaufwand sondern führt auch leicht zur Beschädigung anderer Bauteile.

Es ist daher Aufgabe der Erfindungl eine elektronische Geräteanordnung der eingangs beschriebenen Art zu schaffen, die eine einfache Montage und Demontage von Leiterplatten ermöglicht.

Diese Aufgabe wird erfindungsgemäß dadurch gelost, daß der Leiterplattenhalter im Bereich eine Randkante der stirnseitigen Öffnung des Gehäuses am Gehäuse um eine Schwenkachse schwenkbar angeordnet und aus seiner Einbaulage um die Schwenkachse aus dem Gehäuse heraus schwenkbar ist. Durch die Schwenkbarkeit des Leiterplattenhalters und die Anordnung der Schwenkachse im Bereich der stirnseitigen Öffnung des Gehäuses kann der Leiterplattenhalter zumindest weitgehend aus dem Gehäuse herausgeschwenkt werden, so daß alle Leiterplatten frei zugänglich werden. Ein Ein- und Ausbau anderer Bauteile ist nicht erforderlich, wenn eine neue Bestückung oder Umbestückung der Leiterplatten erfolgt. Auch wird ein Beschädigen anderer Bauteile weitgehend vermieden.

Eine solche Um- oder Neubestückung kann erfolgen ohne den Betrieb der Geräteanordnung zu unterbrechen.

Besonders günstig ist es dabei, wenn der Leiterplattenhalter fest mit der Verschlußtafel verbunden ist und Leiterplattenhalter und Verschlußtafel um eine gemeinsame Schwenkachse aus dem Gehäuse heraus schwenkbar sind. Dadurch wird der Bauaufwand gering gehalten und die Montage und Demontage von Leiterplatten noch weiter vereinfacht.

Vorzugsweise erstreckt sich die Schwenkachse entlang der unteren etwa horizontalen Kante der stirnseitigen Öffnung des Gehäuses, so daß sich bei ausgeschwenktem Kartenhalter die Verschlußtafel unter dem Leiterplattenhalter befindet und nicht stört.

Sind die Steckanschlüsse derart an der Verschlußtafel angeordnet, daß ihr das mit den Leitungen versehene Steckgegenstück aufnehmender Bereich zum Gehäuseäußeren gerichtet ist, so können die externen Anschlusse beim Ausklappen von Leiterplattenhalter und Verschlußtafel weiter angeschlossen bleiben. Sie schwenken dann einfach mit der Verschlußtafel mit, ohne daß eine Zug- oder Druckbelastung auf die Leitungen einwirkt.

Vorteilhafterweise ist an der Verschlußtafel eine Lüftereinheit angeordnet, durch die das Gehäuse von einem Kühlluftstrom von außen angesaugte Luft durchströmbar ist. Dies ist besonders günstig, wenn die Lüftereinheit an der Gehäuseinnenseite der Verschlußtafel angeordnet ist, während auf der der Lüftereinheit gegenüberliegenden Gehäuseaußenseite der Verschlußtafel eine Filtereinheit angeordnet ist und Luft von der Gehäuseaußenseite durch die Filtereinheit und eine entsprechende durchgehende Ausnehmung in der Anschlußtafel von der Lüftereinheit ansaugbar ist. Dann ist nämlich eine leichte Zugänglichkeit zum Auswechseln der Filtermatte der Filtereinheit gegeben. Dazu kann die Filtereinheit aus einem starren, etwa schalenförmigen Filtergrill bestehen, in dessen Schale eine Filtermatte derart einlegbar ist, daß sie zwischen dem Filtergrill und der durchgehenden Ausnehmung der Verschlußtafel angeordnet ist.

Weist der Filtergrill einen oder mehrere Gewindebohrungen auf, in die durch entsprechende Bohrungen in der Verschlußtafel hindurchgeführte Befestigungsschrauben einschraubbar sind, die vorzugsweise Rändelschrauben sind, so ist durch einfaches Lösen der Rändelmuttern der Filtergrill zu lösen und die Filtermatte auszuwechseln. Da die Gewindezapfen in das Gehäuse hineinragen, sind keine von dem Gehäuse nach außen hervorstehende Bauteile vorhanden, an denen man hängenbleiben könnte.

Weist die Verschlußtafel im Schließzustand einen zur vorderen Ebene des Gehäuses etwa paralleien, in das Gehäuseinneren zurückspringend ausgebildeten Bereich auf, an dem die Steckanschlüsse angeordnet sind, und erstreckt sich dabei auch noch der zurückspringend ausgebildete Bereich um etwa das Maß der Länge eines Gegenstücks parallel zur Ebene des Gehäuses, so stehen auch nicht die Gegenstücke über die Gehäuseperipherie hervor. Ein Lockern der Steckgegenstücke durch unbeabsichtigtes Berühren ist somit weitgehend vermieden. Dies insbesondere auch dann, wenn die Leitungen seitlich von den Steckgegenstücken abgehen.

Ist dabei die Schwenkachse an der Randkante des zurückspringenden Bereichs angeordnet, so ergibt sich ein Kanal, durch den die Leitungen ohne vom Gehäuse hervorstehend zu messen, zu anderen externen Einheit geführt werden können.

An den zurückspringenden Bereich kann sich ein sich etwa in der Ebene des Gehäuses erstreckende Bereich der Verschlußtafel anschließen.

Dabei kann in praktisch versenkter Bauweise der übergangsbereich zwischen dem zurückspringenden Bereich und dem sich in der Ebene des Gehäuses erstreckenden Bereich als hintergreifbare Griffmulde ausgebildet sein. Besonders einfach herstellbar ist dabei die Verschlußtafel, wenn sie aus einem Blech etwa Z-förmigen Querschnitts gebildet ist, dessen einer Endschenkel den zurückspringenden Bereich, dessen anderer Endschenkel den sich in der Ebene des Gehäuses erstreckenden Bereich und dessen Verbindungssteg die Griffmulde bildet.

Eine besonders günstige Ausnutzung des vorhandenen Bauraums wird dadurch erreicht, daß die Lüftereinheit in sich in der Ebene des Gehäuses erstreckenden Bereich der Verschlußtafel angeordnet ist.

Die erste Leiterplatte kann je nach Bedarf entweder ohne aktive elektronische Bauteile ausgebildet sein, oder es können aktive elektronische Bauteile auf der ersten Leiterplatte angeordnet sein.

Zur besonders günstigen Kühlung der Wärme produzierenden elektronischen Bauteile ist das Gehäuse in einem Bereich mit Lüftungsschlitzen ausgebildet, zwischen denen und der Belüftereinheit die Leiterplatten angeordnet sind, so daß der Kühlluftstrom immer an den Leiterplatten entlangstreicht.

Besitzt das Gehäuse neben dem durch die Verschlußtafel verschließbaren Bereich einen mit Einschubführungen ausgebildeten und eine Einschuböffnung aufweisenden Einschubbereich, in den elektronische Geräte, die Einschuböffnung verschließend einschiebbar sind, so sind außer den Leiterplatten noch weitere Einheiten im Gehäuse anordenbar.

Vorzugsweise sind im Bereich der Rückwand der Einschuböffnung Steckkontakte angeordnet, in die durch Einschub der elektronischen Geräte in die Einschuböffnung entsprechende Steckgegenstücke an der Rückseite der elektronischen Geräte kontaktierend einführbar sind. Dadurch ergibt sich eine einfache Montage und Demontage der weiteren Einheiten.

Die elektronischen Geräte können Netzteilmodule und/oder Laufwerke sein.

Sind die Steckkontakte über elektrische Leitungen mit der ersten Leiterplatte verbunden, so kann eine Verbindung im Bereich der Schwenkachse erfolgen, so daß bei dem Herausschwenken des Leiterplattenhalters diese Verbindung nicht gelöst werden braucht.

Ein Ausführungsbeispiel ist in der Zeichnung dargestellt und wird im folgenden näher beschrieben. Es zeigen

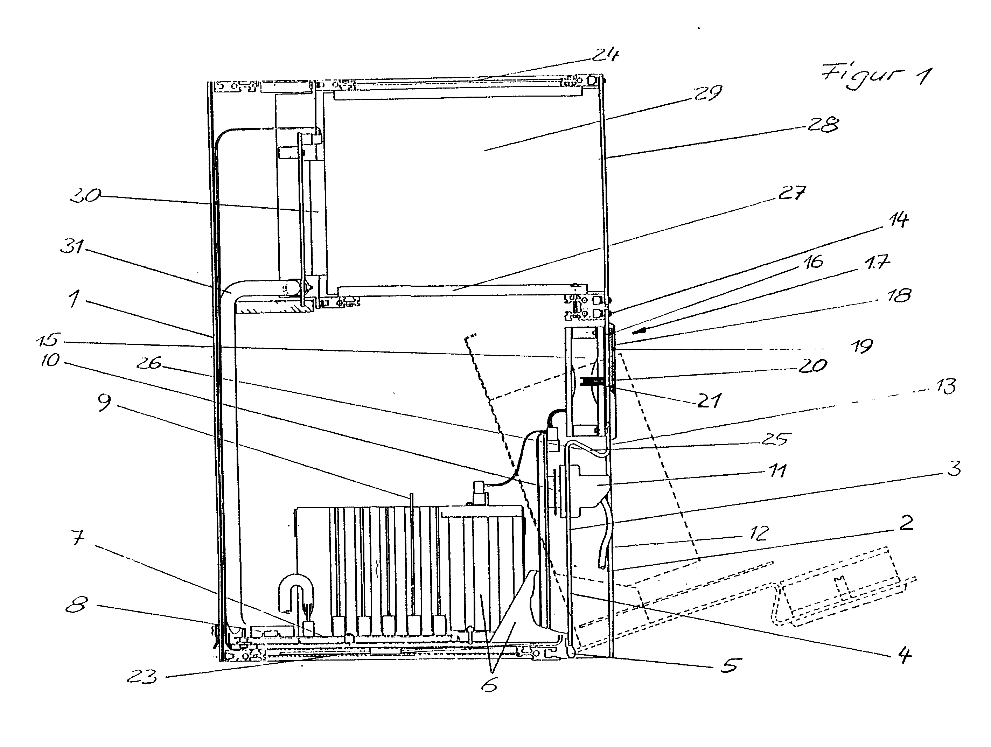

Figur 1 einen Querschnitt einer elektronischen Geräteanordnung,

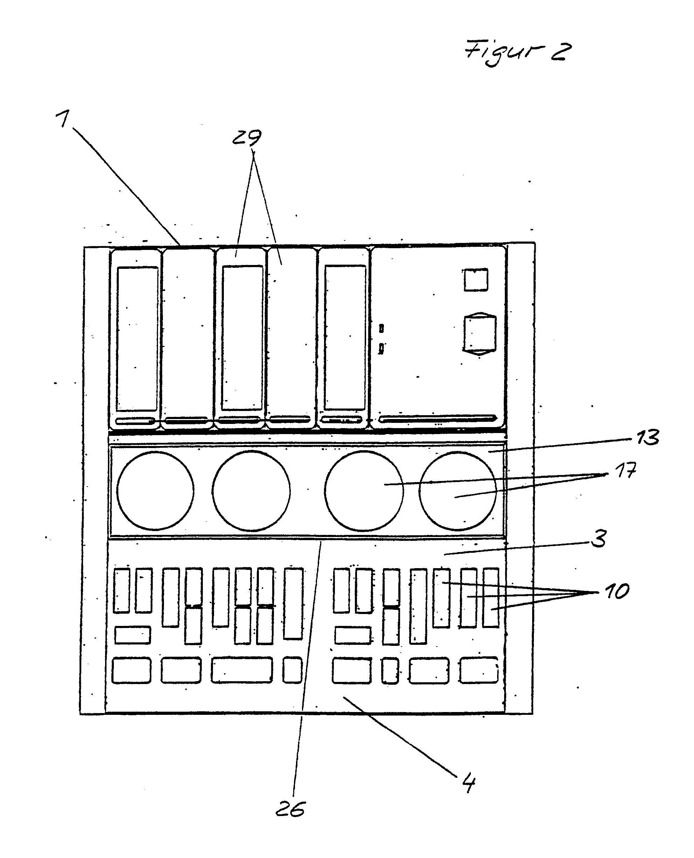

Figur 2 eine Vorderansicht der elektronischen Geräteanordnung nach Figur 1,

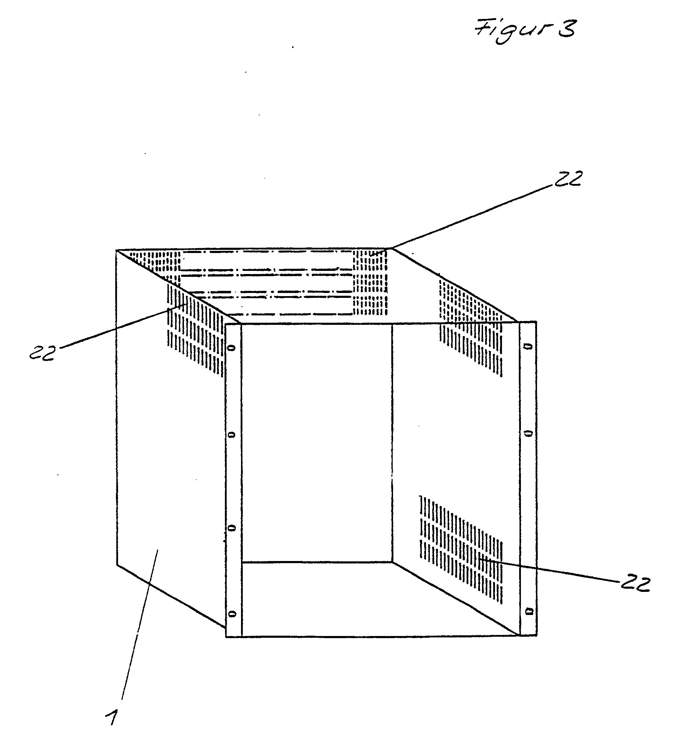

Figur 3 eine perspektivische Ansicht des Gehäuses der elektronischen Geräteanordnung nach Figur 1.

Die in den Figuren dargestellte elektronische Geräteanordnung weist ein Gehäuse 1 auf, das aus elektrisch leitend miteinander verbundenen Blechteilen besteht, so daß eine dem erforderlichen Störschutz genugende Abschirmwirkung erreicht wird.

Der untere Bereich des Gehäuses 1 besitzt eine stirnseitige Öffnung 2, die durch eine Verschlußtafel 3 verschließbar ist. Die Verschlußtafel 3 besteht aus einem Blech Z-förmigen Querschnitts.

Der untere Endschenkel 4 erstreckt sich im geschlossenen Zustand der Verschlußtafel um einen Abstand zurückspringend parallel zur vorderen Ebene des Gehäuses 1.

An seinem unteren Ende ist der Endschenkel 4 am Gehäuse 1 angelenkt und um eine Schwenkachse S aus der mit durchgezogener Linie dargestellten Schließstellung in die mit unterbrochener Linie dargestellte Öffnungsstellung schwenkbar.

Mit der Verschlußtafel 3 ist ein Leiterplattenhalter 6 fest verbunden, auf dem eine in Schließstellung sich etwa parallel zur Bodenfläche des Gehäuses 1 sich erstreckende erste Leiterplatte 7 befestigt ist, auf der aktive elektronische Bauteile 8 angeordnet sind und auf der senkrecht weitere Leiterplatten 9 elektrisch verbindend aufgesteckt sind. Diese weiteren Leiterplatten sind in Führungen des Leiterplattenhalters 6 gehalten und können mit elektronischen Bauteilen versehen sein.

Durch das Verschwenken der Verschlußtafel 3 wird gleichzeitig auch der Leiterplattenhalter 6 mit den Leiterplatten 7 und 9 verschwenkt, so daß diese in Öffnungsstellung sich zumindest weitgehend außerhalb des Gehäuses 1 befinden und so leicht ausgewechselt oder ergänzt werden können.

An dem Leiterplattenhalter 6 und dem unteren Endschenkel 4 der Verschlußtafel 3 sind Steckanschlüsse 10 zum Gehäuseäußeren gerichtet angeordnet, die über Leitungen bzw. Leiterbahnen mit der ersten Leiterplatte 7 verbunden sind und deren Kontaktöffnung durch eine entsprechende Öffnung im unteren Endschenkel 4 ragt. Wie an einem dargestellten Steckanschluß 10 zu sehen ist, ist auf diesen von außen ein Steckgegenstück 11 auf steckbar, das mit einem seitlichen Abgang einer Leitung 12 versehen ist.

Der obere Endschenkel 13 der Verschlußtafel 3 erstreckt sich in der schließstellung etwa in der Ebene des Gehäuses 1 und ist an seinem freien Ende mit einer Schraube 14 am Gehäuse 1 an schraubbar.

Im Bereich des oberen Endschenkels 13 sind an der Innenseite Lüftereinheiten 15 befestigt, die Ober Ausnehmungen 16 in der Verschlußtafel 3 und außenseitig angeordnete Filtereinheiten 17 Luft von außen ansaugen und das Gehäuse zum Kühlen der elektronischen Bauteile durchblasen.

Die Filtereinheiten 17 bestehen aus einem schalenförmigen Filtergrill 18, in dessen Schale eine Filtermatte 19 derart einlegbar ist, daß sie die Ausnehmung 16 überdeckt.

An dem Filtergrill 18 sind Gewindebohrungen 20 ausgebildet, in die durch entsprechende Bohrungen in der Verschlußtafel 3 hindurchgeführte Rändeluchrauben 21 leicht von Rand eingeschraubt werden können, die die Filtereinheit 17 in ihrer Einbaulage halten.

Die von den Lüftereinheiten 15 in das Gehäuseinnere geblasene Luft strömt aus den in den Seitenwänden und der Rückwand des Gehäuses ausgebildeten Lüfterschlitzen 22 und aus den mit einem Lochblech versehenen Boden 23 und Deckel 24 des Gehäuses wieder nach draussen. Der dabei an den Wärme erzeugenden elektronischen Bauteilen vorbeiströmende Luftstrom kühlt diese.

Der die beiden Endschenkel 4 und 13 verbindende Verbindungssteg 25 bildet gleichzeitig eine Griffmulde 26, an der die Verschlußtafel 3 zum Verschwenken erfaßbar ist.

Über dem durch die Verschlußtafel 3 verschließbaren Bereich besitzt das Gehäuse 1 einen weiteren mit Einschubführungen 27 versehenen Bereich, der über der Öffnung 2 nach außen mündende Einschuböffnungen 28 besitzt.

In diese Einschuböffnungen 28 sind mit Führungsgegenstocken versehene elektronische Geräte 29 derart einschiebbar, daß sie mit ihrer Frontseite im eingeschobenen Zustand die Einschuböffnungen 28 verschließen.

Im Bereich der Rückwand der Einschuböffnungen 28 sind Steckkontakte 30 angeordnet, in die entsprechende Steckgegenstücke an der Rückseite der elektronischen Geräte 29 kontaktierend einführbar sind.

Die steckkontakte 30 sind über Leitungen 31 mit der ersten Leiterplatte 7 verbunden.

Dadurch, daß durch die Lüftereinheiten 15 von den Filtereinheiten 17 gereinigte Luft in das Gehäuse 1 eingeblasen wird, entsteht im Gehäuse 1 ein gegenüber dem Gehäuseäußeren etwas erhöhter Druck. Dadurch können keine Verunreinigungen durch Öffnungen und Spalten in das Gehäuse 1 eindringen und zu Beschädigungen elektronischer Bauteile führen.

## Ansprüche

1. Elektronische Geräteanordnung für Schalttafel- oder Pulteinbau mit einem mantelartigen Gehäuse, dessen stirnseitige Öffnung von einer Verschlußtafel verschließbar ist, mit einer etwa parallel zur Bodenfläche des Gehäuses in diesem angeordneten ersten Leiterplatte, auf die etwa senkrecht nach oben stehend mindestens eine gegebenenfalls elektronische Bauteile tragende weitere Leiterplatte mit der ersten Leiterplatte elektrisch verbindend aufsteckbar ist, wobei die erste und die weiteren Leiterplatten auf einem Leiterplattenhalter anordenbar sind, mit Steckanschlüssen, die mit der ersten Leiterplatte elektrisch leitend verbunden sind und an die zu externen Einheiten führende Leitungen anschließbar sind, dadurch gekennzeichnet, daß der Leiterplattenhalter (6) im Bereich einer Randkante der stirnseitigen Öffnung (2) des Gehäuses (1) am Gehäuse (1) um eine Schwenkachse (5) schwenkbar an geordnet und aus seiner Einbaulage um die Schwenkachse (5) aus dem Gehäuse (1) herausschwenkbar ist.
2. Elektronische Geräteanordnung nach Anspruch 1, dadurch gekennzeichnet, daß der Leiterplattenhalter (6) fest mit der Verschlußtafel (3) verbunden ist und Leiterplattenhalter (6) und Verschlußtafel (3) um eine gemeinsame Schwenkachse (5) aus dem Gehäuse (1) herausschwenkbar sind.
3. Elektronische Geräteanordnung nach Anspruch 2, dadurch gekennzeichnet, daß die Schwenkachse (5) entlang der unteren etwa horizontalen Kante der stirnseitigen Öffnung (2) des Gehäuses (1) sich erstreckt.
4. Elektronische Geräteanordnung nach einem der vorhergehenden Ansprüche, dadurch gekennzeichnet, daß die Steckanschlüsse (10) derart an der Verschlußtafel (3) angeordnet sind, daß ihr das mit den Leitungen versehene Steckgegenstück (11) aufnehmender Bereich zum Gehäuseäußeren gerichtet.
5. Elektronische Geräteanordnung nach einem der vorhergehenden Ansprüche, dadurch gekennzeichnet, daß an der Verschlußtafel (3) eine Lüftereinheit (15) angeordnet ist, durch die das Gehäuse (1) von einem Kühl-Luftstrom von außen angesaugter Luft durchströmbar ist.
6. Elektronische Geräteanordnung nach Anspruch 5, dadurch gekennzeichnet, daß die Lüftereinheit (15) an der Gehäuseinnenseite der Verschlußtafel angeordnet ist, während auf der der Lüftereinheit (15) gegenüberliegenden Gehäuseaußenseite der Verschlußtafel (3) eine Filtereinheit (17) angeordnet ist, und Luft von der Gehäuseaußenseite durch die Filtereinheit (17) und eine entsprechende durchgehende Ausnehmung in der Verschlußtafel von der Lüftereinheit (15) ansaugbar ist.

7. Elektronische Geräteanordnung nach Anspruch 6, dadurch gekennzeichnet, daß die Filtereinheit (17) aus einem starren etwa schalenförmigen Filtergrill (18) besteht, in dessen Schale eine Filtermatte (19) derart einlegbar ist, daß sie zwischen dem Filtergrill (18) und der durchgehenden Ausnehmung (16) der Verschlußtafel (3) angeordnet ist.

8. Elektronische geräteanordnung nach Anspruch 7 dadurch gekennzeichnet, daß der Filtergrill (18) einen oder mehrere Gewindebohrungen (20) aufweist, in die durch entsprechende Bohrungen in der Verschlußtafel (3) hindurchgeführte Befestigungsschrauben einschraubbar sind.

9. Elektronische Geräteanordnung nach Anspruch 8, dadurch gekennzeichnet, daß die Befestigungsschrauben Rändelschrauben (21) sind.

10. Elektronische Geräteanordnung nach einem der vorhergehenden Ansprüche, dadurch gekennzeichnet, daß die Verschlußtafel (3) im Schließzustand einen zur vorderen Ebene des Gehäuses (1) etwa parallelen in das Gehäuseinnere zurückspringend ausgebildeten Bereich aufweist, an dem die Steckanschlüsse (10) angeordnet sind.

11. Elektronische Geräteanordnung nach Anspruch 10, dadurch gekennzeichnet, daß der zurückspringend ausgebildete Bereich sich um etwa das Maß der Länge eines Steckgegenstücks (11) parallel zur Ebene des Gehäuses (1) erstreckt.

12. Elektronische Geräteanordnung nach Anspruch 10, dadurch gekennzeichnet, daß die Schwenkachse (5) an der Randkante des zurückspringenden Bereichs angeordnet ist.

13. Elektronische Geräteanordnung nach Anspruch 10, dadurch gekennzeichnet, daß sich an den zurückspringenden Bereich ein sich etwa in der Ebene des Gehäuses (1) erstreckender Bereich der Verschlußtafel (3) anschließt.

14. Elektronische Geräteanordnung nach Anspruch 13, dadurch gekennzeichnet, daß der Übergangsbereich zwischen dem zurückspringenden Bereich und dem sich in der Ebene des Gehäuses (1) erstreckenden Bereich als hintergreifbare Griffmulde ausgebildet ist.

15. Elektronische Geräteanordnung nach Anspruch 14, dadurch gekennzeichnet, daß die Verschlußtafel (3) aus einem Blech etwa Z-förmigen Querschnitts gebildet ist, dessen einer Endschenkel (4) den zurückspringenden Bereich, dessen anderer Endschenkel (13) den sich in der Ebene des Gehäuses (1) erstreckenden Bereich und dessen Verbindungssteg (25) die Griffmulde (26) bildet.

16. Elektronische Geräteanordnung nach Anspruch 5, dadurch gekennzeichnet, daß die Lüftereinheit (15) im sich in der Ebene des Gehäuses (1) erstreckenden Bereich der Verschlußtafel (3) angeordnet ist.

17. Elektronische Geräteanordnung nach einem der vorhergehenden Ansprüche, dadurch gekennzeichnet, daß auf der ersten Leiterplatte (7) aktive elektronische Bauelemente (8) angeordnet sind.

18. Elektronische Geräteanordnung nach einem der vorhergehenden Ansprüche, dadurch gekennzeichnet, daß das Gehäuse (1) in einem Bereich mit Belüftungsschlitzen (22) ausgebildet ist, zwischen dem und der Lüftereinheit (15) die Leiterplatten (7, 8, 9) angeordnet sind.

19. Elektronische Geräteanordnung nach einem der vorhergehenden Ansprüche, dadurch gekennzeichnet, daß das Gehäuse (1) neben dem durch die Verschlußtafel (3) verschließbaren Bereich einen mit Einschubführungen (27) ausgebildeten und eine Einschuböffnung (28) aufweisenden Einschubbereich besitzt, in den elektronische Geräte (29) die Einschuböffnung (28) einschiebbar sind.

20. Elektronische Geräteanordnung nach Anspruch 19, dadurch gekennzeichnet, daß im Bereich der Rückwand der Einschuböffnung (28) Steckkontakte angeordnet sind, in die durch Einschub der elektronischen Geräte (29) in die Einschuböffnung (28) entsprechende Steckgegenstücke an der Rückseite der elektronischen Geräte (29) kontaktierend einführbar sind.

21. Elektronische Geräteanordnung nach Anspruch 19, dadurch gekennzeichnet, daß die elektronischen Geräte (29) Netzteilmodule und/oder Laufwerke sind.

22. Elektronische Geräteanordnung nach Anspruch 20, dadurch gekennzeichnet, daß die Steckkontakte (30) über elektrische Leitungen (31) mit der ersten Leiterplatte (7) verbunden sind.

Figur 1

EP 0 421 096 A2

Figur 2

Figur 3